(19) Europäisches Patentamt
European Patent Office
Office européen des brevets

(11) **EP 2 136 406 B1**

(12) **EUROPEAN PATENT SPECIFICATION**

(45) Date of publication and mention
of the grant of the patent:
**28.08.2013 Bulletin 2013/35**

(51) Int Cl.:
*H01L 29/786* *(2006.01)*    *H01L 29/45* *(2006.01)*

(21) Application number: **09251375.3**

(22) Date of filing: **21.05.2009**

(54) **Thin film transistor, method of manufacturing the same, and flat panel display device having the same**

Dünnschichttransistor, Verfahren zu dessen Herstellung und Flachbildschirmvorrichtung mit diesem Transistor

Transistor à couche mince, son procédé de fabrication et dispositif à écran plat doté de celui-ci

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **18.06.2008 KR 20080057250**

(43) Date of publication of application:
**23.12.2009 Bulletin 2009/52**

(73) Proprietor: **Samsung Display Co., Ltd.**
**Gyeonggi-Do (KR)**

(72) Inventors:
• **Jeong, Jae Kyeong**
**Yongin-city,**
**Gyunggi-do 446-711 (KR)**
• **Shin, Hyun Soo**
**Yongin-city,**
**Gyunggi-do 446-711 (KR)**
• **Mo, Yeon Gon**
**Yongin-city,**
**Gyunggi-do 446-711 (KR)**

(74) Representative: **Mounteney, Simon James**
**Marks & Clerk LLP**
**90 Long Acre**
**London**
**WC2E 9RA (GB)**

(56) References cited:
US-A- 5 747 930      US-A1- 2006 001 366
US-A1- 2007 057 261      US-A1- 2007 108 446
US-A1- 2008 017 891

• **S.M. SZE: 'Physics of semiconductor Devices', JOHN WILEY & SONS pages 250 - 251**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a thin film transistor. Particularly, but not exclusively, the invention relates to a thin film transistor that uses an oxide semiconductor as an active layer, a method of manufacturing the same, and a flat panel display device having the same.

Generally, in a thin film transistor manufactured by a semiconductor process, an active layer having a channel region, a source region, and a drain region is formed of a semiconductor, such as amorphous silicon or poly-silicon. However, if the active layer is formed of amorphous silicon, the active layer has low mobility so that it is difficult to operate a driving circuit at a high speed. Also, if the active layer is formed of poly-silicon, the active layer has a high mobility but a non-uniform threshold voltage so that a separate compensation circuit is necessary.

As an example, in the case of applying the thin film transistor with an active layer of poly-silicon to a display device, a need exists for a compensation circuit having five thin film transistors and two capacitors in order to maintain a uniform threshold voltage and the high mobility. Accordingly, a complicated process and a number of masks are used thus increasing manufacturing cost and decreasing yield.

Recently, in order to solve these problems, a study on a use of oxide semiconductor as the active layer has been conducted.

The thin film transistor using zinc oxide (ZnO) or an oxide semiconductor mainly constituted by the zinc oxide (ZnO) as the active layer is disclosed in the Japanese Patent Publication No. 2004-273614.

However, a conventional thin film transistor using the oxide semiconductor as the active layer has poor ohmic contact with a metal electrode due to a wide band gap of the oxide semiconductor.

US 2007/0184446 discloses a thin film transistor according to the preamble of Claim 1.

[0007a] US 2008/0017891 and US 2007/0057261 disclose known transistor structures.

## SUMMARY OF THE INVENTION

Aspects of the present invention provide a thin film transistor, a method of manufacturing the same, and a flat panel display device having the same capable of improving ohmic contact characteristics of an oxide semiconductor layer and a metal electrode.

According to an aspect of the present invention there is provided a thin film transistor as claimed in Claim 1.

According to an aspect of present Invention there is provided a method of manufacturing a thin film transistor as claimed in Claim 8.

According to an aspect of the present invention there is provided a flat panel display device as claimed in Claim 13.

According to aspects of the present invention, the ohmic contact layer is formed between the oxide semiconductor layer and the metal electrode and of the metal alloy having a low work function. Therefore, height of aSchottky barrier is reduced by the ohmic contact layer so that contact resistance between the oxide semiconductor layer and the source and drain electrodes is lowered. Thereby, a current-voltage characteristic is improved so that an electrical characteristic of the device may be improved.

The above and other features of the invention are set out in the appended claims.

The invention will become more apparent and more readily appreciated from the following description of the embodiments, taken in conjunction with the accompanying drawings of which:

FIG. 1 is a cross-sectional view of a thin film transistor not in accordance with the present invention;
FIG. 2 is a cross-sectional view of a thin film transistor not in accordance with the present invention;
FIG. 3 is a cross-sectional view of a thin film transistor not in accordance with the present invention;
FIG. 4 is a cross-sectional view of a thin film transistor according to an embodiment of the present invention;
FIGs. 5A to 5E are cross-sectional views illustrating a method of manufacturing thin film transistors;
FIGs. 6 to 9 are band diagrams before and after junction of a metal and an oxide semiconductor;
FIG. 10 is a perspective view of a flat panel display device having the thin film transistor according to embodiments of the present invention;
FIGs. 11A and 11B are perspective views of a flat panel display device having the thin film transistor according to embodiments of the present invention; and
FIG. 12 is a cross-sectional view of an organic light emitting element in FIG. 11A.

In the following detailed description, only certain embodiments of the present invention have been shown and described, simply by way of illustration. As those skilled in the art would realize, the described embodiments may be modified in various different ways, all without departing from the scope of the present invention. Accordingly, the drawings and description are to be regarded as illustrative in nature and not restrictive. In addition, when an element is referred to as being "on," "formed on," or "disposed on" another element, it can be directly on, formed directly on, or disposed directly on another element or one or more intervening elements may be disposed therebetween. Also, when an element is referred to as being "connected to," "coupled to," or "electrically coupled to" another element, it can be directly connected to another element or be indirectly connected to another element with one or more intervening elements interposed therebetween. Hereinafter, like reference numerals refer to like elements.

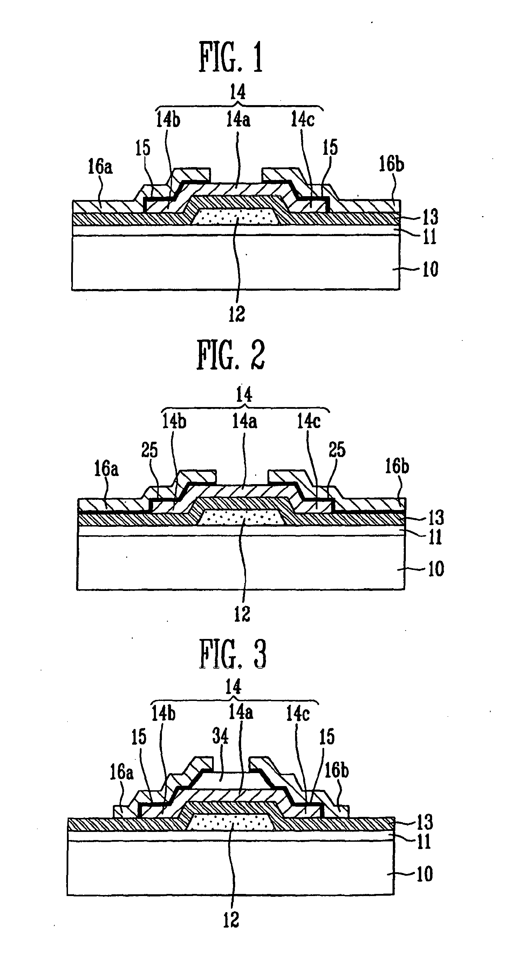

FIG. 1 is a cross-sectional view of a thin film transistor, wherein an example of a bottom gate structure is shown. Although explained with respect to a bottom gate thin film transistor, aspects of the present invention may be applied to a top gate thin film transistor. A buffer layer 11 is formed on a substrate 10, and a gate electrode 12 is formed on the buffer layer 11. A gate insulating layer 13 is formed on an upper surface of the substrate 10 on which the gate electrode 12 is formed. An oxide semiconductor layer 14 is formed as an active layer having a channel region 14a, a source region 14b, and a drain region 14c and formed on the gate insulating layer 13 corresponding to the gate electrode 12. An ohmic contact layer 15 is formed on the source region 14b and the drain region 14c of the oxide semiconductor layer 14. Also, source and drain electrodes 16a and 16b are formed to contact the source region 14b and the drain region 14c through the ohmic contact layer 15.

The oxide semiconductor layer 14 includes zinc oxide (ZnO), and may be doped with at least one ion of gallium (Ga), indium (In), tin (Sn), zirconium (Zr), hafnium (Hf), cadmium (Cd), silver (Ag), copper (Cu), germanium (Ge), gadolinium (Gd), and vanadium (V). The oxide semiconductor layer14 may be formed of ZnO, ZnGaO, ZnInO, ZnSnO, GaInZnO, CdO, InO, GaO, SnO, AgO, CuO, GeO, GdO, HfO, etc., for example.

The ohmic contact layer15 reduces contact resistance between the source region 14b and the drain region 14c of the oxide semiconductor layer 14 and the source and drain electrodes 16a and 16b, which are made of a metal. Accordingly, the ohmic contact layer 15 is formed of a metal having a lower work function than a work function of a metal from which the source and drain electrodes 16a and 16b are formed.

In the case where the source and drain electrodes 16a and 16b are formed of a metal, such as molybdenum (Mo), tungsten (W), aluminum (Al), titanium (Ti), etc., the work functions of these metals is approximately 4 eV or more. Therefore, the ohmic contact layer 15 is formed of a metal with work function of 2 to 4 eV. Such a metal includes an alkali metal such as calcium (Ca) (2.9 eV), magnesium (Mg) (3.7 eV), potassium (K) (2.3 eV), lithium (Li) (2.9 eV), etc. However, since such an alkali metal has a chemically high reactivity, the alkali metal may be easily changed by a chemical reaction. Therefore, the ohmic contact layer 15 may be formed of an alloy, such as magnesium-silver (Mg-Ag), lithium-aluminum (Li-Al), aluminum-silver (Al-Ag), lithium-fluorine (LiF), etc., in order to prevent such chemical change.

FIG. 2 is a cross-sectional view of a thin film transistor. Herein, only the differences between the structures shown in FIG. 1 and FIG. 2 will be described.

The thin film transistor in FIG. 1 has a structure that the ohmic contact layer 15 is formed only on the source region 14b and the drain region 14c of the oxide semiconductor layer 14. On the other hand, the thin film transistor in FIG. 2 has a structure that an ohmic contact layer 25 is formed on lower surfaces of the source and drain electrodes 16a and 16b. The ohmic contact layer 25 is formed to overlap the source and drain electrodes 16a and 16b. Therefore, it is possible to pattern the ohmic contact layer 25 and the source and drain electrodes 16a and 16b with one mask, thereby decreasing mask numbers and process steps as compared to FIG. 1.

FIG. 3 is a cross-sectional view of a thin film transistor. Herein, only the differences between the structures shown in FIG. 1 and FIG. 3 will be described. While the thin film transistor in FIG. 1 has a structure that the channel region 14a of the oxide semiconductor layer 14 is exposed, the thin film transistor in FIG. 3 has a structure that a passivation layer 34 is formed on the channel region 14a of the oxide semiconductor layer 14. The passivation layer 34 isformed of an inorganic material or an insulating organic material, such as a polyimide-based resin, etc.

The oxide semiconductor layer 14 is easily damaged by plasma or easily etched by acid chemicals, etc. Therefore, in the structure that the oxide semiconductor layer 14 is exposed, when forming a thin film thereon or etching a formed thin film, damage may occur so that a change in an electrical characteristic, such as increase of carriers, occurs. Because of such a change in the electrical characteristic of the oxide semiconductor layer 14, an electrical characteristic of the thin film transistor may be deteriorated and a dispersive degree of the electrical characteristics in the substrate may be deteriorated.

However, in an etching process forming the source and drain electrodes 16a and 16b, the channel region 14a of the oxide semiconductor layer 14 is protected by the passivation layer 34 and at the same time, the passivation layer 34 may be used as an etch stop layer. Therefore, the damage of the oxide semiconductor layer 14 by the plasma or the acid chemicals is effectively prevented and at the same time, the process is simplified.

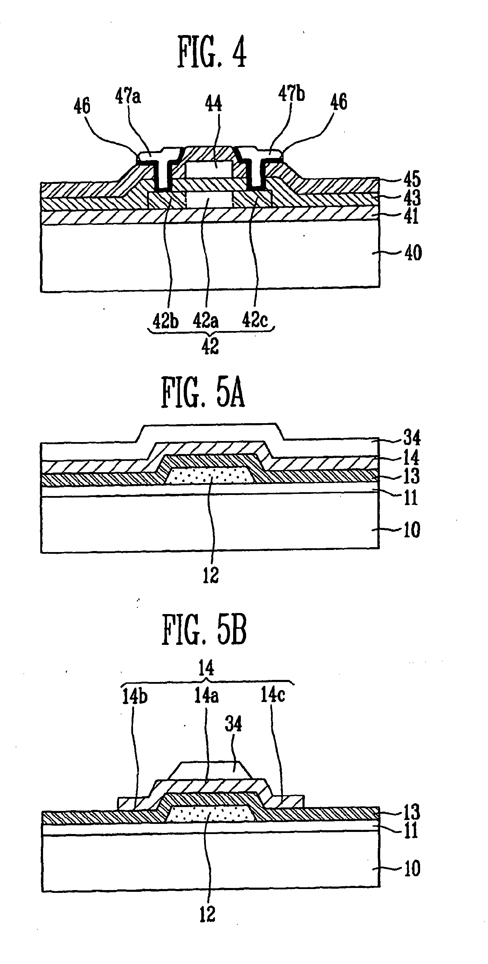

FIG. 4 a cross-sectional view of a thin film transistor according to an embodiment of the present invention, wherein an example of a top gate structure is shown. A buffer layer 41 is formed on a substrate 40, and an oxide semiconductor layer 42 is formed as an active layer having a channel region 42a, a source region 42b, and a drain region 42c on the buffer layer 41. A gate insulating layer 43 is formed on an upper surface of the oxide semiconductor layer 42, and a gate electrode 44 is formed on the gate insulating layer 43 on an upper surface of the oxide semiconductor layer 42, i.e., the gate electrode is formed on the gate insulating layer 43 in an area corresponding to the oxide semiconductor layer 42. An insulating layer 45 is formed on an upper surface to cover the gate electrode 44, and contact holes are formed in the insulating layer 45 and the gate insulating layer 43 so that portions of the source region 42b and the drain region 42c of the oxide semiconductor layer 42are exposed. An ohmic contact layer 46 is formed to cover surfaces of the contact holes formed in the insulating layer 45 and the gate insulating layer 43. The ohmic contact layer 46 further covers the exposed portions of the source region 42b and the drain region 42c of the oxide semiconductor layer 42 exposed through the contact holes. Source and drain electrodes 47a and 47b are formed to be coupled to the source region 42b and the drain region 42c through the ohmic contact layer 46.

Although a case where the ohmic contact layer 46 is formed to correspond with the source and drain electrodes 47a and 47b is shown in FIG. 4, the ohmic contact layer 46 may also be formed only on the exposed portions of the oxide semiconductor layer 42. Further, the ohmic contact layer 46 may be formed on the entire source and drain regions 42b and 42c of the oxide semiconductor region 42, between the source and drain regions 42b and 42c and the gate insulating layer 43.

The oxide semiconductor layer 42 includes zinc oxide (ZnO), and may be doped with at least one ion of gallium (Ga), indium (In), tin (Sn), zirconium (Zr), hafnium (Hf), cadmium (Cd), silver (Ag), copper (Cu), germanium (Ge), gadolinium (Gd), and vanadium (V). The oxide semiconductor layer 42 may be formed of ZnO, ZnGaO, ZnlnO, ZnSnO, GalnZnO, CdO, InO, GaO, SnO, AgO, CuO, GeO, GdO, HfO, etc., for example.

The ohmic contact layer 46 reduces contact resistance between the source region 42b and the drain region 42c of oxide semiconductor layer 42 and the source and drain electrodes 47a and 47b, which are made of a metal. Accordingly, the ohmic contact layer 46 is formed of a metal alloy having a work functionlower than a work function of a metal from which the source and drain electrodes 47a and 47b are formed.

In the case where the source and drain electrodes 47a and 47b are formed of a metal, such as molybdenum (Mo), tungsten (W), aluminum (Al), titanium (Ti), etc., the work functions of these metals are approximately 4 eV or more. Therefore, the ohmic contact layer 46 is formed of a metal alloy with the work function of about 2 to 4 eV. Such a metal includes an alkali metal, such as calcium (Ca) (2.9 eV), magnesium (Mg) (3.7 eV), potassium (K) (2.3 eV), lithium (Li) (2.9 eV), etc. However, since such an alkali metal has a chemically high reactivity, it may be easily changed by a chemical reaction. Therefore, the ohmic contact layer 46 is formed of an alloy, selected from magnesium-silver (Mg-Ag), lithium-aluminum (Li-Al), aluminum-silver (Al-Ag), lithium-fluorine (LiF), in order to prevent such chemical change.

FIGs. 5A to 5E are cross-sectional views illustrating a method of manufacturing a thin film transistor. Herein, the structure in FIG. 3 will be explained as an example.

Referring to FIG. 5A, after forming the buffer layer 11 on the substrate 10, the gate electrode 12 Is formed on the buffer layer 11. The gate insulating layer 13, the oxide semiconductor layer 14, and the passivation layer 34 are sequentially formed on the upper surface of the substrate having the gate electrode 12 formed thereon.

As the substrate 10, a semiconductor substrate, such as silicon (Si), an insulating substrate, such as glass or plastic or a metal substrate may be used. The gate electrode 12 is formed of a metal such, as Al, Cr, MoW, etc., and the gate insulating layer 13 is formed of an insulating material, such as $SiO_2$, $SiN_x$, $GaO_3$, etc. The oxide semiconductor layer 14 includes zinc oxide (ZnO), wherein the ZnO may be doped with at least one ion of gallium (Ga), Indium (In), tin (Sn), zirconium (Zr), hafnium (Hf), cadmium (Cd), silver (Ag), copper (Cu), germanium (Ge), gadolinium (Gd), and vanadium (V). The oxide semiconductor layer 14 is formed of ZnO, ZnGaO, ZnlnO, ZnSnO, GalnZnO, CdO, InO, GaO, SnO, AgO, CuO, GeO, GdO, HfO, etc., for example. Also, the passivation layer 34 is formed of an inorganic material or an insulating organic material, such as a polylmide-based resin, etc.

Referring to FIG 5B, the oxide semiconductor layer 14 is patterned so that a channel region 14a, a source region 14b, and a drain region 14c are defined, and the passivation layer 34 is patterned so that It remains only on the channel region 14a of the oxide semiconductor 14.

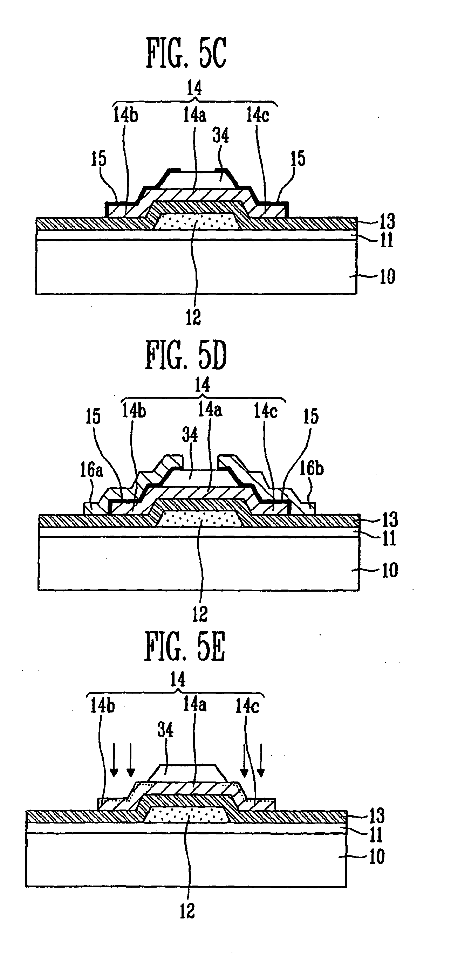

Referring to FIG. 5C, after forming the ohmic contact layer 15 over the whole upper surface of substrate having the patterned passivation layer 34 and the patterned oxide semiconductor layer 14, the ohmic contact layer 15 is patterned so that it remains only on the source region 14b and the drain region 14c of the oxide semiconductor layer 14 and the passivation layer 34, i.e., the ohmic contact layer 15 is patterned to correspond to areas on which source and drain electrodes 16a and 16b are to be formed. However, the ohmic contact layer 15 may be patterned as described above with respect to FIGs. 1-4.

Referring to FIG. 5D, the source and drain electrodes 16a and 16b are formed to be coupled to the source region 14b and the drain region 14c through the ohmic contact layer 15. The source and drain electrodes 16a and 16b are formed of a metal, such as molybdenum (Mo), tungsten (W), aluminum (Al), titanium (Ti), or are formed of an alloy thereof. The source and drain electrodes 16a and 16b may be formed in a stacked structure of the metal and/or alloy thereof. Further, in the case of a transparent thin film transistor, the source and drain electrodes 16a and 16b may be formed of a transparent conductive material, such as indium tin oxide (ITO), indium zinc oxide (IZO), indium tin zinc oxide (ITZO), etc.

Referring to FIG. 5E, it is possible to irradiate plasma on the exposed source and drain regions 14b and 14c on both sides of the passivation layer 34 in the operation of patterning the oxide semiconductor layer 14 and the passivation layer 34 as in FIG. 5B. In such case, oxygen vacancy occurs due to lattice damage by the plasma. Due to an increase in effect carrier, electric conductivities of surfaces of the source region 14b and the drain region 14c increase so that contact resistance between the source region 14b and the drain region 14c of the oxide semiconductor layer 14 and the source and drain electrodes 16a and 16b may be effectively reduced.

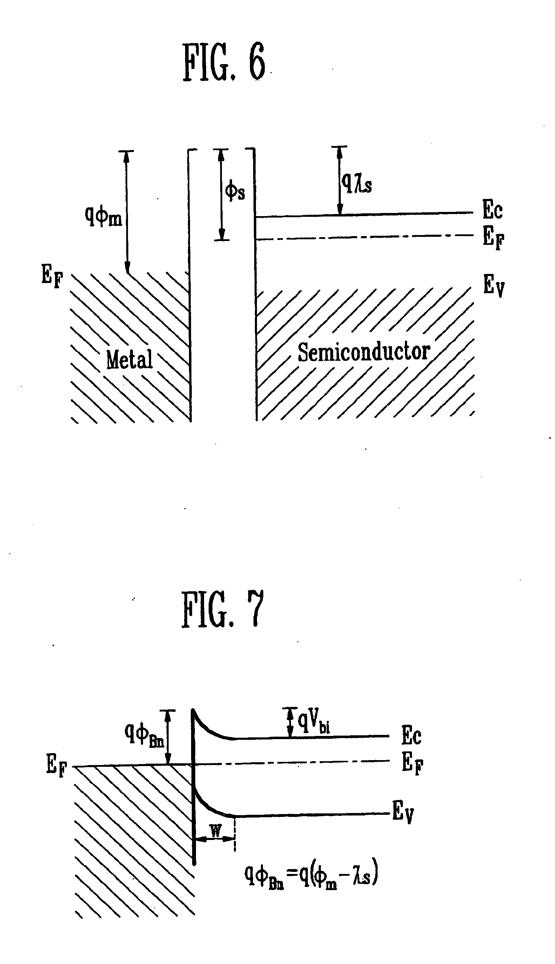

Next, aspects of the present invention capable of effectively reducing the contact resistance between the oxide semiconductor layer 14 and the source and drain electrodes 16a and 16b will be described with reference to FIGs. 6 to 9.

FIG. 6 is a band diagram before junction of a metal and an oxide semiconductor (for example, ZnO), wherein the work function of the metal is larger than that of an n-type oxide semiconductor ($\phi$m > $\phi$s). The conduction band $E_c$ and the valence band $E_v$ are indicated for the semiconductor, and the Fermi energies $E_F$ of both the metal and the semiconductor are indicated. A general metal corresponds to such a band diagram.

FIG. 7 is a band diagram after the junction of the metal and the oxide semiconductor (for example, ZnO), wherein some electrons of the oxide semiconductor are diffused toward the metal so that a depletion region is formed in the oxide semiconductor in the vicinity of the interface between metal and the oxide semiconductor. As a result, a Schottky barrier is formed so that in the case of no interfacial states, an ohmic contact characteristic is not indicated. At this time, the contact resistance Rc may be indicated as in Equation. 1 below.

[Equation 1]

$$Rc = [\frac{k}{qA\mathcal{E}T}]\exp(q\frac{\Phi_{Bn}}{kT})$$

Herein, T indicates a temperature, A indicates a Richardson constant, k indicates a Boltzmann constant, and $q\Phi_{Bn}$ indicates the Schottky barrier.

In the Equation 1, since it is possible to approximate $q\ \Phi_{Bn} = q\ \Phi_M - q\chi_s$ ($\boldsymbol{q}\ \Phi_M$. indicates the work function of the metal, and $\boldsymbol{q}\chi_s$ indicates electron affinity), a height of the Schottky barrier is determined by the electron affinity of the metal and the oxide semiconductor. As the work function of the metal becomes smaller, the height of the Schottky barrier is reduced so that the contact resistance is reduced.

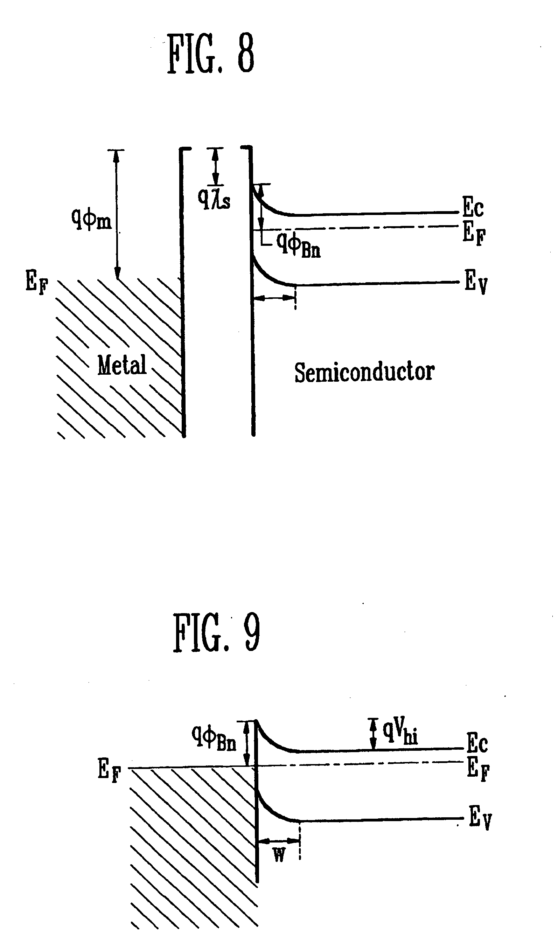

FIG. 8 is a band diagram after the junction of the metal and the oxide semiconductor (for example, ZnO) in the case where a number of surface states exist on a surface of the oxide semiconductor, wherein the electron on the surface of the oxide semiconductor is trapped in an interface state so that the depletion region is formed. This is referred to as Fermi level pinning.

FIG. 9 is a band diagram after the junction of the metal and a Fermi level pinned oxide semiconductor. At this time, the height of the Schottky barrier is independent of the work function of the metal. This is referred to as the Bardeen limit.

As described above, according to aspects of the present invention, the ohmic contact layer is formed of the metal with a low work function between the oxide semiconductor layer and the metal electrode. The height of the Schottky barrier is reduced by the ohmic contact layer so that the contact resistance between the oxide semiconductor layer and the metal electrode is reduced. Thereby, current-voltage characteristics of the thin film transistor may be improved.

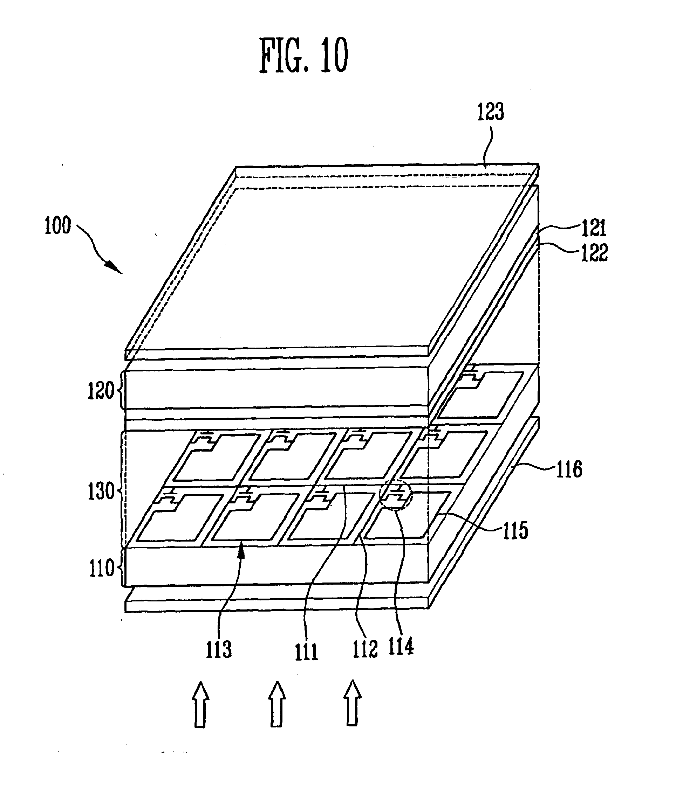

FIG. 10 is a perspective view of a flat panel display device having a thin film transistor according to aspects of the present invention. Hereinafter, a display panel 100 to display an image will be described.

The display panel 100 comprises two substrates 110 and 120 disposed to face each other and a liquid crystal layer 130 disposed between the two substrates 110 and 120. In the display panel 100, a pixel region 113 is defined by a plurality of scan lines 111 and a plurality of data lines 112 arranged in a matrix form on the substrate 110. Also, a thin film transistor 114 to control signals supplied to each pixel and a pixel electrode 115 coupled to the thin film transistor 114 are formed on the substrate 110 in each of the pixel regions 113.

The thin film transistor 114 has any one of the structures in FIGs. 1 to 4, and may be manufactured according to the method described with reference to FIGs. 5A to 5E.

Also, a color filter 121 and a common electrode 122 are formed on the substrate 120. Polarizing plates 116 and 123 are formed on rear surfaces of the substrates 110 and 120, respectively, and a backlight (not shown) is disposed as a light source under the polarizing plate 116.

Meanwhile, a driver (LCD drive IC, not shown) to drive the display panel 100 is mounted in the circumferential area of the pixel region 113 of the display panel 100. The driver converts an electrical signal provided from the outside into a scan signal and a data signal to supply them to the scan lines 111 and the data lines 112.

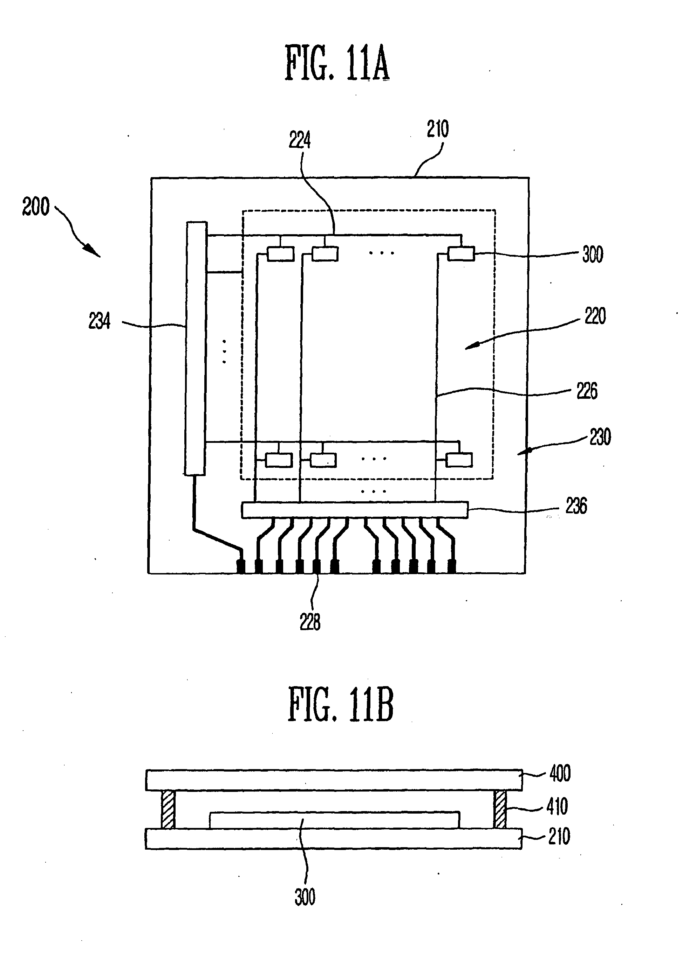

FIGs. 11A and 11 B are a plan view and a cross-sectional view of a flat panel display device having a thin film transistor according to aspects of the present invention. Hereinafter, a display panel 200 to display an image will be described.

Referring to FIG. 11A, a substrate 210 includes a pixel region 220 and a non-pixel region 230 surrounding the pixel region 220. A plurality of organic light emitting elements 300 coupled in a matrix form between scan lines 224 and data lines 226 are formed on the substrate 210 in the pixel region 220. A scan line 224 and a data line 226 extends from the pixel region 220 to the non-pixel region 230 and are supplied with signals from a scan driver 234 and a data driver 236, respectively. A power supply line (not shown) supplies power to the organic light emitting element 300., The scan driver 234 and a data driver 236 process signals provided from the outside through a pad 228 to supply the processed signals to the scan line 224 and the data line 226, respectively. The scan driver 234, the data driver 236, the power supply line, and the pad are formed on the substrate 210 in the non-pixel region 230.

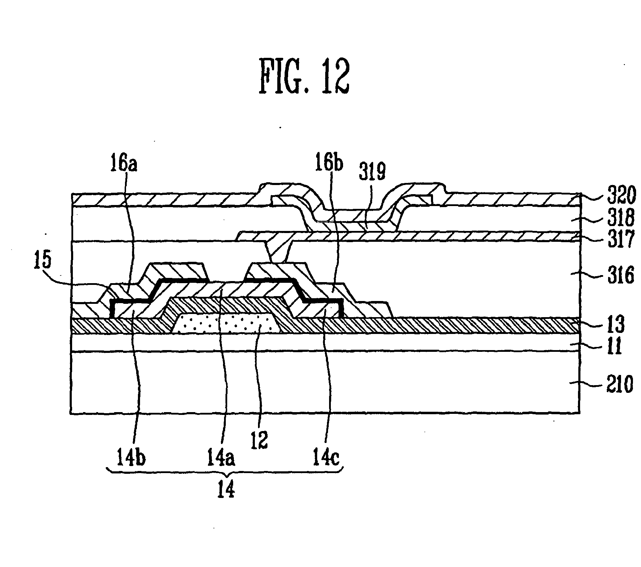

Referring to FIG. 12, the organic light emitting diode 300 comprises an anode electrode 317, a cathode electrode 320, and an organic thin film layer 319 formed between the anode electrode 317 and the cathode electrode 320. The organic thin film layer 319 is formed having a structure in which a hole transport layer, an organic light emitting layer, and an electron transport layer are stacked. Further, the organic thin film layer 319 may include a hole injection layer, a hole blocking layer, an electron blocking layer, and an electron injection layer, among others. Further, each of the layers of the organic light emitting diode 300 may include stacked layers. Also, the organic light emitting diode 300 can further include a thin film transistor to control the operation of the organic light emitting element 300 and a capacitor to maintain the signal.

The thin film transistor may have any one of the structures in FIGs. 1 to 4, and may be manufactured according to the manufacturing method described with reference to FIGs. 5A to 5E.

The organic light emitting element 300 including the thin film transistor as described above will be described in detail with reference to FIGs. 11A and 12. The buffer layer 11 is formed on the substrate 210 in the pixel region 220, and the gate electrode 12 is formed on the buffer layer 11. At this time, the pixel region 220 may be formed with the scan line 223 coupled to the gate electrode 12, and the non pixel region 230 may be formed with the scan line 224 extended from the pixel region 220 and the pad 228 that receives the signal from the outside.

The oxide semiconductor layer 14 is formed on the gate insulating layer 13 on the gate electrode 12 and electrically insulated from the gate electrode 12 by the gate insulating layer 13. The ohmic contact layer 15 is formed on the source region 14b and the drain region 14c of the oxide semiconductor layer 14, and the source and drain electrodes 16a and the 16b are formed to be coupled to the source region 14b and the drain region 14c through the ohmic contact layer 15. At this time, the pixel region 220 may be formed with the data line 226 coupled to one of the source and drain electrodes 16a and 16b, and the non-pixel region 230 may be formed with the data line 226 extended from the pixel region 220 and the pad 228 that receives the signal from the outside.

Thereafter, a planarization layer 316 to planarize the entire surface of the pixel region 220 is formed. A via-hole is formed in the planarization layer 316 so that a portion of the source electrode 16a or the drain electrode 16b is exposed, and the anode electrode 317 is formed and coupled to the source electrode 16a or the drain electrode 16b through the via-hole.

A pixel definition film 318 is formed on the planarization layer 316 so that a partial region (light emitting region) of the anode region 317 is exposed, and the organic thin film layer 319 is formed on the exposed anode electrode 317. The cathode electrode 320 is formed on the pixel definition film 318 to cover the organic thin film layer 319.

Referring to FIG. 11 B, a sealing substrate 400 sealing the pixel region 220 is disposed on the upper surface of the substrate 210 on which the organic light emitting elements 300 are formed as described above. The sealing substrate 400 is bonded to the substrate 210 by a sealant 410 so that the display panel is completed.

Although a few embodiments of the present invention have been shown and described, it would be appreciated by those skilled in the art that changes may be made in this embodiment without departing from the principles of the invention, the scope of which is defined in the claims and their equivalents.

## Claims

1. A thin film transistor, comprising:

a substrate (40);
an oxide semiconductor layer (42) having a channel region(42a), a source region (42b), and a drain region (42c);
a gate efectrode (44) formed over the oxide semiconductor layer (42);
a gate insulating layer (43) formed between the oxide semiconductor layer (42) and the gate electrode (44);
an ohmic contact layer (46): and
a source electrode (47a) and a drain electrode (47b) respectively electrically coupled to the source region (42a) and the drain region (42b) through the ohmic contact layer(46); and
wherein an insulating layer (45) is formed to cover the gate electrode (46);
**CHARACTERISED IN THAT**:

wherein the source electrode (47a) and the drain electrode (47b) are disposed on the insulating layer (45) and connected to the source region (42a) and the drain region (42b) through via holes formed in the insulating layer (45) and the gate insulating layer (43);
wherein the ohmiccontact layer (46) is formed on and in contact with the source region (42b) and the drain region (42c) of the oxide semiconductor layer (42) and to cover surfaces in the via holes; and
wherein the ohmic contact layer (46) is formed of a metal alloy having a lower work function than work functions of the source electrode (47a) and the drain electrode (47b), the alloy selected from a group consisting of magnesium-silver, lithnm-aluminum, aluminum-silver and lithium-fluorine.

2. A thin film transistor according to claim 1, wherein the oxide semiconductor layer (42) comprises zinc oxide (ZnO).

3. A thin film transistor according to claim 1 or 2, wherein the oxide semiconductor layer (42) is doped with at least one ion of gallium (Ga), indium (In), tin (Sn), zirconium (Zr), hafnium (Hf), cadmium (Cd), silver (Ag), copper (Cu), germanium (Ge), gadolinium (Gd), and vanadium (V).

4. A thin film transistor according to any preceding claim, wherein the ohmic contact layer (46) is disposed between the source electrode (47a) and the oxide semiconductor layer (42) and between the drain electrode (47b) and the oxide semiconductor layer (42).

5. A thin film transistor according to any preceding claim, further comprising a buffer layer (41) disposed between the substrate and the oxide semiconductor layer.

6. A thin film transistor according to any preceding claim, wherein the ohmic contact layer (46) is disposed between the source electrode (47a) and the insulating layer (45), between the source electrode (47a) and the gate insulating layer (43), between the drain electrode (47b) and the insulating layer (45), and between the drain electrode (47b) and the gate insulating layer (43).

7. A thin film transistor according to any preceding claim, wherein the ohmic contact layer (46) is disposed on walls of the via holes formed in the insulating layer (45) and the gate insulating layer (43).

8. A method of manufacturing a thin film transistor, the method comprising the following steps in no particular order:

forming an oxide semiconductor layer (42) having a channel region (42a), a source region (42b), and a drain region (42c) on a substrate;
forming a gate insulating layer (43) on the semiconductor layer;
forming a gate electrode (44) on the gate insulating layer (43);
**CHARACTERISED BY**:

the said method further comprising
either
forming via holes in the gate insulating layer (43) to expose portions of the source region (42b) and the drain region (42c); and
forming the ohmic contact layer (46) on the exposed portions of the source region (42b) and the drain region (42c);
or
forming the ohmic layer (46) on the source region (42b) and the drain region (42c) and;
forming via holes in the gate insulating layer (43) to expose portions of the ohmic contact layer on the source region (42b) and the drain region (42c);
the method further comprising forming a source electrode(47a) and a drain electrode (47b) so as to be respectively electrically coupled to the source region (42b) and the drain region(42c) through the ohmic contact layer (46);
wherein the ohmic contact layer (48) is formed of a metalalloy having a lower work function than work functions of the source electrode(47a) and the drain electrode (47b), the alloy selected from a group consisting of magnesium-silver lithium, aluminum, aluminum-silver and lithium-fluorine.

9. A method according to claim 8, wherein the oxide semiconductor layer (42) comprises zinc oxide (ZnO).

10. A method according to claims 8 or 9, wherein the oxide semiconductor layer is doped with at least one ion of gallium (Ga), indium (In), tin (Sn), zirconlum (Zr), hafnium (Hf), cadmium (Cd), silver (Ag), copper (Cu), germanium (Ge), gadolinium (Gd), and vanadium (\/).

11. A method according to one of claims 8 to 10, wherein the ohmic contact layer (48) is formed to be disposed between the source electrode(47a) and the source region (42b) and between the drain electrode (47b) and the drain region (42c).

12. A method according to one of claims 8 to 11, further comprising irradiating plasma on the source region (42b) and the drain region (42c) of the oxide semiconductor layer (42).

13. A flat panel display device having a thin film transistor, comprising:

a first substrate(110) having disposed thereon:

first (111) and second (112) conductive lines,
a pixel (115) having a first electrode and being served by the first conductive line (111) and the second conductive line (117), and
a thin film transistor(114) electrically coupled to the first electrode(111) to control signals supplied to the pixel (115); and

a second substrate(120)
wherein the thin filmtransistor (114) is as set out in one of claims 1 to 7, its gate electrode(44) is electrically connected to one of the first (111) and second (112) conductive lines, one of its source electrode (47a) and drain electrode (47b) is electrically connected to the other of the first(111) and second (112) conductive lines. and the other of the source electrode(47a) and the drain electrode (47b) is electrically connected to the first electrode.

14. A flat panel display device according to claim 13, further comprising a second electrode(122) disposed on the second substrate (120) and a liquid crystal layer (130) disposed in a sealed space between the first electrode and the second electrode(122).

15. A flat panel display device according to claim 13 wherein the pixel comprises an organic light emitting element including a second electrode.

**Patentansprüche**

1. Dünnschichttransistor, der Folgendes umfasst:

ein Substrat (40);
eine Oxidhalbleiterschicht (42) mit einer Kanalregion (42a), einer Source-Region (42b) und einer Drain-Region (42c);
eine über der Oxidhalbleiterschicht (42) ausgebildete Gatterelektrode (44);
eine zwischen der Oxidhalbleiterschicht (42) und der Gatterelektrode (44) ausgebildete Gatterisolierschicht (43);
eine ohmsche Kontaktschicht (46); und
eine Source-Elektrode (47a und eine Drain-Elektrode (47b), die durch die ohmsche Kontaktschicht (46) jeweils mit der Source-Region (42a) und der Drain-Region (42b) elektrisch gekoppelt sind; und
wobei eine Isolierschicht (45) zum Bedecken der Gatterelektrode (46) ausgebildet ist;
**dadurch gekennzeichnet, dass**:

die Source-Elektrode (47a) und die Drain-Elektrode (47b) auf der Isolierschicht (45) angeordnet und mit der Source-Region (42a) und der Drain-Region (42b) durch Durchkontaktierungslöcher verbunden sind, die in der Isolierschicht (45) und der Gatterisolierschicht (43) ausgebildet sind;
wobei die ohmsche Kontaktschicht (46) auf und in Kontakt mit der Source-Region (42b) und der Drain-Region (42c) der Oxidhalbleiterschicht (42) und zum Bedecken von Oberflächen in den Durchkontaktierungslöchern ausgebildet ist; und

wobei die ohmsche Kontaktschicht (46) aus einer Metalllegierung mit einer niedrigeren Austrittsarbeit als Austrittsarbeiten der Source-Elektrode (47a) und der Drain-Elektrode (47b) gebildet ist, wobei die Legierung aus einer Gruppe bestehend aus Magnesium-Silber, Lithium-Aluminium, Aluminium-Silber und Lithium-Fluor ausgewählt ist.

2. Dünnschichttransistor nach Anspruch 1, wobei die Oxidhalbleiterschicht (42) Zinkoxid (ZnO) beinhaltet.

3. Dünnschichttransistor nach Anspruch 1 oder 2, wobei die Oxidhalbleiterschicht (42) mit wenigstens einem Ion von Gallium (Ga), Indium (In), Zinn (Sn), Zirkonium (Zr), Hafnium (Hf), Cadmium (Cd), Silber (Ag), Kupfer (Cu), Germanium (Ge), Gadolinium (Gd) und Vanadium (V) dotiert ist.

4. Dünnschichttransistor nach einem der vorherigen Ansprüche, wobei die ohmsche Kontaktschicht (46) zwischen der Source-Elektrode (47a) und der Oxidhalbleiterschicht (42) sowie zwischen der Drain-Elektrode (47b) und der Oxidhalbleiterschicht (42) angeordnet ist.

5. Dünnschichttransistor nach einem der vorherigen Ansprüche, der ferner eine Pufferschicht (41) zwischen dem Substrat und der Oxidhalbleiterschicht aufweist.

6. Dünnschichttransistor nach einem der vorherigen Ansprüche, wobei die ohmsche Kontaktschicht (46) zwischen der Source-Elektrode (47a) und der Isolierschicht (45), zwischen der Source-Elektrode (47a) und der Gatterisolierschicht (43), zwischen der Drain-Elektrode (47b) und der Isolierschicht (45) sowie zwischen der Drain-Elektrode (47b) und der Gatterisolierschicht (43) angeordnet ist.

7. Dünnschichttransistor nach einem der vorherigen Ansprüche, wobei die ohmsche Kontaktschicht (46) an Wänden der in der Isolierschicht (45) und der Gatterisolierschicht (43) ausgebildeten Durchkontaktierungslöcher angeordnet ist.

8. Verfahren zur Herstellung eines Dünnschichttransistors, wobei das Verfahren die folgenden Schritte nicht in einer bestimmten Reihenfolge beinhaltet:

Ausbilden einer Oxidhalbleiterschicht (42) mit einer Kanalregion (42a), einer Source-Region (42b) und einer Drain-Region (42c) auf einem Substrat;
Ausbilden einer Gatterisolierschicht (43) auf der Halbleiterschicht;
Ausbilden einer Gatterelektrode (44) auf der Gatterisolierschicht (43);
**dadurch gekennzeichnet,**
**dass** das Verfahren ferner Folgendes beinhaltet:

entweder
Ausbilden von Durchkontaktierungslöchern in der Gatterisolierschicht (43), um Abschnitte der Source-Region (42b) und der Drain-Region (42c) zu exponieren; und
Ausbilden der ohmschen Kontaktschicht (46) auf den exponierten Abschnitten der Source-Region (42b) und der Drain-Region (42c);
oder
Ausbilden der ohmschen Schicht (46) auf der Source-Region (42b) und der Drain-Region (42c), und
Ausbilden von Durchkontaktierungslöchern in der Gatterisolierschicht (43), um Abschnitte der ohmschen Kontaktschicht auf der Source-Region (42b) und der Drain-Region (42c) zu exponieren;
wobei das Verfahren ferner das Ausbilden einer Source-Elektrode (47a) und einer Drain-Elektrode (47b) beinhaltet, um durch die ohmsche Kontaktschicht (46) jeweils mit der Source-Region (42b) und der Drain-Region (42c) elektrisch verbunden zu sein;
wobei die ohmsche Kontaktschicht (46) aus einer Metalllegierung mit einer niedrigeren Austrittsarbeit als Austrittsarbeiten der Source-Elektrode (47a) und der Drain-Elektrode (47b) ausgebildet ist, wobei die Legierung aus einer Gruppe bestehend aus Magnesium-Silber, Lithium-Aluminium, Aluminium-Silber und Lithium-Fluor ausgewählt ist.

9. Verfahren nach Anspruch 8, wobei die Oxidhalbleiterschicht (42) Zinkoxid (ZnO) beinhaltet.

10. Verfahren nach Anspruch 8 oder 9, wobei die Oxidhalbleiterschicht mit wenigstens einem Ion von Gallium (Ga), Indium (In), Zinn (Sn), Zirkonium (Zr), Hafnium (Hf), Cadmium (Cd), Silber (Ag), Kupfer (Cu), Germanium (Ge), Gadolinium (Gd) und Vanadium (V) dotiert ist.

11. Verfahren nach einem der Ansprüche 8 bis 10, wobei die ohmsche Kontaktschicht (46) so ausgebildet ist, dass sie zwischen der Source-Elektrode (47a) und der Source-Region (42b) sowie zwischen der Drain-Elektrode (47b) und der Drain-Region (42c) angeordnet ist.

12. Verfahren nach einem der Ansprüche 8 bis 11, das ferner das Bestrahlen der Source-Region (42b) und der Drain-Region (42c) der Oxidhalbleiterschicht (42) mit Plasma beinhaltet.

13. Flachanzeigegerät mit einem Dünnschichttransistor, das Folgendes umfasst;
ein erstes Substrat (110), auf dem Folgendes angeordnet ist:

   eine erste (111) und eine zweite (112) leitfähige Leitung,
   ein Pixel (115) mit einer ersten Elektrode, das von der ersten leitfähigen Leitung (111) und der zweiten leitfähigen Leitung (117) gespeist wird, und
   einen Dünnschichttransistor (114), der elektrisch mit der ersten Elektrode (111) gekoppelt ist, um dem Pixel (115) zugeführte Signale zu steuern; und
   ein zweites Substrat (120),
   wobei der Dünnschichttransistor (114) wie in den Ansprüchen 1 bis 7 dargelegt ist, seine Gatterelektrode (44) elektrisch mit einer der ersten (111) und der zweiten (112) leitfähigen Leitungen verbunden ist, eine von seiner Source-Elektrode (47a) und seiner Drain-Elektrode (47b) elektrisch mit der anderen aus erster (111) und zweiter (112) leitfähiger Leitung verbunden ist, und die andere aus Source-Elektrode (47a) und DrainElektrode (47b) elektrisch mit der ersten Elektrode verbunden ist.

14. Flachanzeigegerät nach Anspruch 13, das ferner eine auf dem zweiten Substrat (120) angeordnete zweite Elektrode (122) und eine in einem versiegelten Raum zwischen der ersten Elektrode und der zweiten Elektrode (122) angeordnete Flüssigkristallschicht (130) umfasst.

15. Flachanzeigegerät nach Anspruch 13, wobei das Pixel ein organisches Leuchtelement mit einer zweiten Elektrode umfasst.


**Revendications**

1. Transistor à couches minces, comprenant:

   un substrat (40);
   une couche d'oxyde semi-conducteur (42) ayant une région de canal (42a), une région de source (42b) et une région de drain (42c) ;
   une électrode de grille (44) formée au-dessus de la couche d'oxyde semi-conducteur (42);
   une couche isolante de grille (43) formée entre la couche d'oxyde semi-conducteur (42) et l'électrode de grille (44);
   une couche de contact ohmique (46); et
   une électrode de source (47a) et une électrode de drain (47b) respectivement couplées électriquement à la région de source (42a) et à la région de drain (42b) par l'intermédiaire de la couche de contact ohmique (46); et
   dans lequel une couche isolante (45) est formée de manière à couvrir l'électrode de grille (46);
   **caractérisé en ce que**
   l'électrode de source (47a) et l'électrode de drain (47b) sont disposées sur la couche isolante (45) et connectées à la région de source (42a) et à la région de drain (42b) par l'intermédiaire de trous traversants formés dans la couche isolante (45) et la couche isolante de grille (43);
   la couche de contact ohmique (46) est formée sur et en contact avec la région de source (42b) et la région de drain (42c) de la couche d'oxyde semi-conducteur (42) et de manière à couvrir des surfaces dans les trous traversants; et
   la couche de contact ohmique (46) est constituée d'un alliage métallique ayant une fonction d'extraction plus faible que les fonctions d'extraction de l'électrode de source (47a) et de l'électrode de drain (47b), l'alliage étant sélectionné dans un groupe consistant en du magnésium-argent, du lithium-aluminium, de l'aluminium-argent et du lithium-fluor.

**2.** Transistor à couches minces selon la revendication 1, dans lequel la couche d'oxyde semi-conducteur (42) comprend de l'oxyde de zinc (ZnO).

**3.** Transistor à couches minces selon la revendication 1 ou 2, dans lequel la couche d'oxyde semi-conducteur (42) est dopée avec au moins un ion de gallium (Ga), d'indium (In), d'étain (Sn), de zirconium (Zr), d'hafnium (Hf), de cadmium (Cd), d'argent (Ag), de cuivre (Cu), de germanium (Ge), de gadolinium (Gd) et de vanadium (V).

**4.** Transistor à couches minces selon l'une quelconque des revendications précédentes, dans lequel la couche de contact ohmique (46) est disposée entre l'électrode de source (47a) et la couche d'oxyde semi-conducteur (42) et entre l'électrode de drain (47b) et la couche d'oxyde semi-conducteur (42).

**5.** Transistor à couches minces selon l'une quelconque des revendications précédentes, comprenant en outre une couche tampon (41) disposée entre le substrat et la couche d'oxyde semi-conducteur.

**6.** Transistor à couches minces selon l'une quelconque des revendications précédentes, dans lequel la couche de contact ohmique (46) est disposée entre l'électrode de source (47a) et la couche isolante (45), entre l'électrode de source (47a) et la couche isolante de grille (43), entre l'électrode de drain (47b) et la couche isolante (45), et entre l'électrode de drain (47b) et la couche isolante de grille (43).

**7.** Transistor à couches minces selon l'une quelconque des revendications précédentes, dans lequel la couche de contact ohmique (46) est disposée sur des parois des trous traversants formés dans la couche isolante (45) et la couche isolante de grille (43).

**8.** Procédé de fabrication d'un transistor à couches minces, le procédé comprenant les étapes suivantes dans aucun ordre particulier :

de formation d'une couche d'oxyde semi-conducteur (42) ayant une région de canal (42a), une région de source (42b) et une région de drain (42c) sur un substrat ;
de formation d'une couche isolante de grille (43) sur la couche semi-conductrice,
de formation d'une électrode de grille (44) sur la couche isolante de grille (43) ;
**caractérisé en ce que**
ledit procédé comprend en outre :

soit
la formation de trous traversants dans la couche isolante de grille (43) pour exposer des parties de la région de source (42b) et de la région de drain (42c) ; et
la formation de la couche de contact ohmique (46) sur les parties exposées de la région de source (42b) et de la région de drain (42c) ;
soit
la formation de la couche ohmique (46) sur la région de source (42b) et la région de drain (42c) ; et
la formation de trous traversants dans la couche isolante de grille (43) pour exposer des parties de la couche de contact ohmique sur la région de source (42b) et la région de drain (42c) ;
le procédé comprenant en outre la formation d'une électrode de source (47a) et d'une électrode de drain (47b) de manière à ce qu'elles soient respectivement couplées électriquement à la région de source (42b) et à la région de drain (42c) par l'intermédiaire de la couche de contact ohmique (46) ;
dans lequel la couche de contact ohmique (46) est constituée d'un alliage métallique ayant une fonction d'extraction plus faible que les fonctions d'extraction de l'électrode de source (47a) et de l'électrode de drain (47b), l'alliage étant sélectionné dans un groupe consistant en du magnésium-argent, du lithium-aluminium, de l'aluminium-argent et du lithium-fluor.

**9.** Procédé selon la revendication 8, dans lequel la couche d'oxyde semi-conducteur (42) comprend un oxyde de zinc (ZnO).

**10.** Procédé selon la revendication 8 ou 9, dans lequel la couche d'oxyde semi-conducteur est dopée avec au moins un ion de gallium (Ga), d'indium (In), d'étain (Sn), de zirconium (Zr), d'hafnium (Hf), de cadmium (Cd), d'argent (Ag), de cuivre (Cu), de germanium (Ge), de gadolinium (Gd) et de vanadium (V).

**11.** Procédé selon l'une des revendications 8 à 10, dans lequel la couche de contact ohmique (46) est formée de manière à être disposée entre l'électrode de source (47a) et la région de source (42b) et entre l'électrode de drain (47b) et la région de drain (42c).

12. Procédé selon l'une des revendications 8 à 11, comprenant en outre l'irradiation de la région de source (42b) et de la région de drain (42c) de la couche d'oxyde semi-conducteur (42) avec un plasma.

13. Dispositif d'affichage à panneau plat comportant un transistor à couches minces, comprenant :

un premier substrat (110) sur lequel sont disposés :

des première (111) et deuxième (112) lignes conductrices,
un pixel (115) ayant une première électrode et étant desservi par la première ligne conductrice (111) et la deuxième ligne conductrice (117), et
un transistor à couches minces (114) couplé électriquement à la première électrode (111) pour commander les signaux appliqués au pixel (115) ; et
un deuxième substrat (120),
dans lequel le transistor à couches minces (114) est selon l'une quelconque des revendications 1 à 7, son électrode de grille (44) est connectée électriquement à l'une des première (111) et deuxième (112) lignes conductrices, l'une de son électrode de source (47a) et de son électrode de drain (47b) est connectée électriquement à l'autre des première (111) et deuxième (112) lignes conductrices, et l'autre de l'électrode de source (47a) et de l'électrode de drain (47b) est connectée électriquement à la première électrode.

14. Dispositif d'affichage à panneau plat selon la revendication 13, comprenant en outre une deuxième électrode (122) disposée sur le deuxième substrat (120) et une couche de cristal liquide (130) disposée dans un espace scellé entre la première électrode et la deuxième électrode (122).

15. Dispositif d'affichage à panneau plat selon la revendication 13, dans lequel le pixel comprend un élément électroluminescent organique comprenant une deuxième électrode.

## FIG. 1

## FIG. 2

## FIG. 3

## FIG. 4

## FIG. 5A

## FIG. 5B

## FIG. 5C

14
14b   14a   14c
15    34    15
13
11
10
12

## FIG. 5D

14
14b   14a   14c
15    34    15
16a   16b
13
11
10
12

## FIG. 5E

14
14b   14a   14c
34
13
11
10
12

# FIG. 6

# FIG. 7

$$q\phi_{Bn} = q(\phi_m - \lambda_s)$$

## FIG. 8

$q\phi_m$

$q\lambda_s$

$q\phi_{Bn}$

$E_F$

Metal

Semiconductor

$E_c$
$E_F$
$E_V$

## FIG. 9

$q\phi_{Bn}$

$qV_{hi}$

$E_F$

W

$E_c$
$E_F$
$E_V$

EP 2 136 406 B1

# FIG. 10

18

# FIG. 11A

# FIG. 11B

# FIG. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004273614 A
- US 20070184446 A
- US 20080017891 A
- US 20070057261 A